Europäisches Patentamt

European Patent Office

Office européen des brevets

(19)

(11) Publication number: **0 193 543 B1**

(12)

# EUROPEAN PATENT SPECIFICATION
## published in accordance with Art. 158(3) EPC

(45) Date of publication of patent specification: **10.04.91**  (51) Int. Cl.5: **G03F 7/38**, G03F 7/095

(21) Application number: **85903964.6**

(22) Date of filing: **07.08.85**

(86) International application number:
**PCT/US85/01490**

(87) International publication number:
**WO 86/01313 (27.02.86 86/05)**

Divisional application 89202373.0 filed on 07/08/85.

(54) **PROCESS FOR FORMING A LAYER OF PATTERNED PHOTORESIST.**

(30) Priority: **13.08.84 US 639875**

(43) Date of publication of application:
**10.09.86 Bulletin 86/37**

(45) Publication of the grant of the patent:
**10.04.91 Bulletin 91/15**

(84) Designated Contracting States:
**DE FR GB NL**

(56) References cited:
**EP-A- 0 103 337**
**GB-A- 1 146 297**

**IBM Technical Disclosure Bulletin, vol 26, nr 3B, August 1983, New York (US) CT Horng et al: "Superposition of Photoresist Patterns", page 1728**

(73) Proprietor: **NCR CORPORATION**

**World Headquarters**
**Dayton, Ohio 45479(US)**

(72) Inventor: **MAHERAS, George**
**655 Zuni Circle**
**Fort Collins, CO 80526(US)**
Inventor: **HAYWORTH, Hubert, Oscar**
**655 Zuni Circle**
**Fort Collins, CO 80526(US)**
Inventor: **GULETT, Michael, Raymond**
**41403 Timber Creek Terrace**
**Fremont, CA 94538(US)**

(74) Representative: **Robinson, Robert George**
**International Patent Department NCR Limited**
**206 Marylebone Road**
**London NW1 6LY(GB)**

IBM Technical Disclosure Bulletin, vol 21, nr 9, February 1979, New York, (US) GT Chin et al: "Resist Lift-off mask with controllable overhand thickness", page 3623

IBM Technical Disclosure Bulletin, vol 19, nr 1, June 1976, New York (US) T Gardner et al: " Double-Resist Layer Shadow Masking", page 156-157

Patent Abstract of Japan, vol 1, nr 18, 24 March 1977, page 413E76 & JP A 511114931

IBM Technical Disclosure Bulletin, vol 25, nr 11B, April 1983, New York (US) E Bassous et al: " Forming Resist images by portable conformable Masking Technique", pages 5922-5924

IBM Technical Disclosure Bulletin, vol 21, nr 5, October 1978, New York (US) BJ Lin: "Portable intimately contacted Mask", page 2133

IBM Technical Disclosure Bulletin, vol 19, nr 3, August 1976, New York (US) C Johnson et al: "Single Coat Photoresist Lift-off Structure", page 859

Institute of Electrical & Electronics Engineers International Electron Devices Meeting, technical digest Washington, 6-8 December 1976, New York (US) Tadahiro & Hashimoto et al: " A new Photomask with Ion-implanted Resist", pages 198-200

IBM Technical Disclosure Bulletin, vol 15, nr 1, June 1972, New York (US) DF Iltey et al: "Flash heatment of Photoresist", page 45

## Description

This invention relates to processes of the kind for forming a layer of patterned photoresist on a substrate, including the steps of: forming on said substrate a first layer of polymeric photoresist material; and converting first selected regions of said first layer to monomeric form by exposing said regions to depolymerizing wavelength energy.

A particular application of the invention is to photolithographic barrier masking as applied to semiconductor process technology.

The production of large scale integrated circuit semiconductor devices by the formation of patterned photoresist, interchangeably referred to herein as a resist, barrier layers on semiconductor wafers, interchangeably referred to herein as substrates, requires that such photoresist layers be sufficiently precise in shape and location to allow the reliable manufacture of extremely small structural configurations, and further that such layers be free of spurious hole defects. It is commmonly known that the presence of such "pinhole" defects can when masking dielectric layers expose such layers to unwanted etching therethrough, and consequential short circuit paths following metallization. Because a defect in a single conductive path or device can cause a complete integrated circuit chip, consisting of thousands of such devices, to be inoperative, the elimination of such flaws has given rise to a variety of techniques aimed at holding their occurrence to an absolute minimum. Subsequent discussions will be concerned mainly with the use of such barrier layers as etching barriers; however, the limitations of the prior art and the advantages of the present invention thereover are equally applicable with respect to the common practice of using such patterns as selective masks for deposition, ion implantation, diffusion, lift-off, etc. operations.

Positive photoresists, those presently preferred for semiconductor processing, are usually formed from a polymer dissolved in an appropriate carrier solvent to create a lacquer, which lacquer is applied by conventional spin-on techniques to form a thin solid layer over a substrate after the carrier solvent is removed by evaporation. A subsequent selective exposure of the resist layer to depolymerizing wavelength radiation passed through a patterned mask, or alternatively by means of a direct projection of such actinic radiation, causes local depolymerization of the irradiated resist to the form of a monomer. Subsequent immersion of the resist coated substrate into a developer solvent having the ability to dissolve the resulting monomer, while having no substantial attack rate on the unexposed polymer, causes a retention of the desired polymer photoresist pattern. Alternatively, the selectively exposed layer may be "dry developed" by exposure to ionic plasmas of certain gases having similar selective dissolving characteristics.

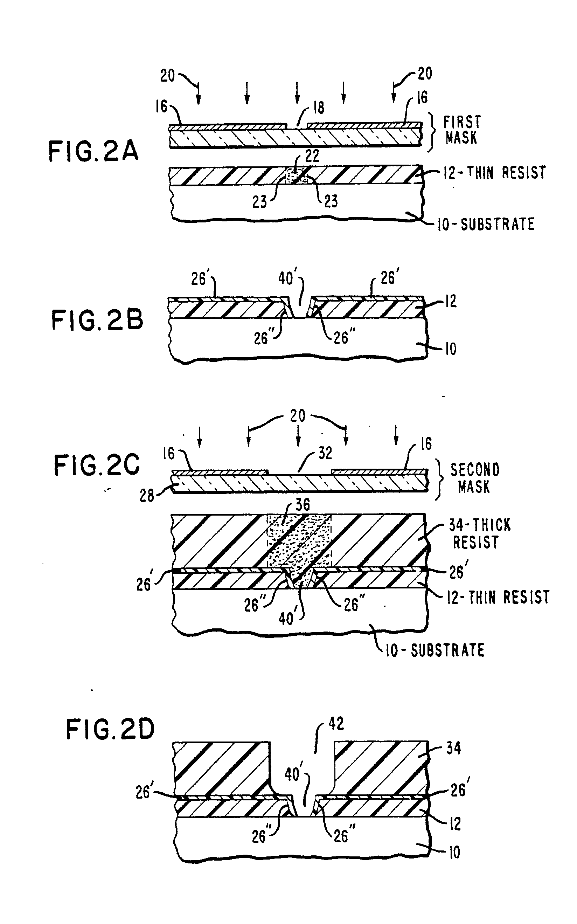

For maximum resolution, i.e. to produce the smallest apertures in the resist, the thickness of the resist layer must be held to values of 500 nanometers or less. Unfortunately, resist barriers this thin very frequently exhibit flaws, in the nature of random pinhole defects. Such flaws arise from a variety of sources, including dust particles in the photolithographic system and mask defects. To prevent such pinholes in the resist barrier from giving rise to spurious etching patterns, one possible technique (see Figs. 2A-2D) is to apply a second substantially thicker resist layer, initially in liquid form as before and frequently of the same composition as the first resist layer, over the first layer, after the first layer has been developed and suitably processed (hardened). This technique will be described in detail since it contrasts with, but is helpful in understanding, the present invention. The hardening ensures that the first layer is separated by an insoluble barrier from the carrier solvents in the second layer. The hardening process will be discussed subsequently. However, it should be recognized that without such a hardening process the carrier solvents of the second resist layer would immediately attack the patterned first layer of resist when the second layer is applied.

This second photoresist layer can have a thickness in the range of 1000 to 2000 nanometers, a thickness sufficient to be substantially free of pin holes, but too thick to allow the formation of patterns as finely detailed as in a 500 nanometer thick layer. In addition, to avoid the position correspondence of mask defect induced pin holes which might appear in even 2000 nanometer photoresist, the second layer is exposed to an actinic radiation pattern using a different mask, with a slightly coarser pattern. Thereby, the second layer is exposed over and around the immediate region of the small, high resolution, aperture in the first layer. Upon subsequent development, the composite two-layer structure would in principle provide a high resolution aperture in the first layer communicating with a correspondingly positioned yet somewhat larger aperture in the upper layer.

However, this approach would cause a loss of resolution as to small passages in the first layer because the region of the first layer defining each high resolution aperture has been exposed and developed twice. It is well-known in the art that a single exposure and development cycle tends to produce positive sloping aperture walls. Two such exposure and development cycles increase the degree of the slope in the first layer, leaving a tapered rather than vertical photoresist aperture. A tapered aperture is undesirable, particularly if the photoresist mask is to subsequently be employed to define an ion implant pattern. Thus, there remains a need for a high resolution photoresist process which provides a resist barrier which is adequately pinhole free, and which also maintains the requisite shape of the high resolution photoresist pattern resolution. A successful process would preferably also be characterized by a reduced number of handling steps as compared with the above mentioned two layer process, such as would be obtained if the process required only one development step.

From EP-A-O 103 337, there is known a method of manufacturing a semiconductor device in which a photosensitive lacquer layer which includes a polymeric material and a sensitizer with a diazo group and a ketone group is formed on a substrate. After a patterning irradiation but before development, the lacquer layer is subjected to an intermediate treatment which includes first and second irradiations. During the first irradiation an ester compound is formed in a top layer of the parts of the lacquer layer which had not previously been irradiated. By a second irradiation at least a part of the sensitizer is then converted into an acid in the parts of the lacquer layer below the top layer. Thus, differences in solubility when the lacquer layer is developed are obtained in a direction in the thickness of the lacquer layer of the parts of the lacquer layer which were not exposed during the patterning irradiation.

From IBM Technical Disclosure Bulletin, vol. 26, No. 3B (August 1983), page 1728, there is known a method of superimposing photoresist patterns including the steps of (a) plasma treating a developed positive photoresist pattern; (b) post-baking the plasma treated pattern; (c) spin coating and baking a second layer of positive photoresist; and (d) over-exposing and over-developing the second layer of photoresist using the same or another mask.

From IBM Technical Disclosure Bulletin, vol. 25, No. 11B (April 1983) , pages 5922-5924, there is known a process which produces high-aspect-ratio resist images using a portable conformable mask (PCM) technique. A relatively thick deep-UV resist such as PMMA is deposited and prebaked and a relatively thin novolac-based resist is provided thereon and prebaked, with an interfacial layer being formed to prevent the bottom resist from being dissolved by the novolac casting solvents. The top resist is then exposed and developed. The interfacial layer is plasma ashed and the bottom layer is developed. Finally quench development and rinsing are performed.

From IBM Technical Disclosure Bulletin, vol. 21, No.9 (February 1979), page 3623, there is known a process wherein a 1.2-micron thick layer of photoresist is blanket exposed to ultraviolet radiation and then subject to treatment with a gaseous plasma. A second 1.2-micron thick layer of photoresist is deposited on top of the first layer, baked, and patternwise exposed to ultraviolet radiation. The structure is then developed to remove the exposed portions of the second layer and underlying portions of the first layer.

From IBM Technical Disclosure Bulletin, vol. 21, No.5 (October 1978), page 2133, there is known a process wherein a top photoresist layer is processed into an exposure mask for a bottom photoresist layer. The top layer is exposed and developed and then serves as an intimately contacted flood exposure mask for the bottom layer.

From Patent Abstracts of Japan, vol 1, No. 18, 24 March 1977, page 413E76, Abstract No. 51-114931, there is known a photoresist patten formation method wherein a first photoresist layer is deposited, masked and exposed, whereafter a second photoresist layer is deposited, masked and exposed. The development process follows.

It is the object of the present invention to provide a process of the kind specified, whereby a high resolution patterned photoresist layer may be provided in a simple manner.

Therefore, according to the present invention, there is provided a process of the kind specified, characterized by the steps of: after said step of converting, conditioning said first layer, to form from a surface region of said polymeric photoresist material a surface layer which is substantially opaque to depolymerizing wavelength energy without materially affecting said first selected regions; forming on said substrate a second layer of polymeric photoresist material having a thickness greater than the thickness of said first layer; converting to monomeric form second selected regions of said second layer overlying said selected regions by exposing said second selected regions to depolymerizing wavelength energy; and developing out the monomeric material from said first selected regions and from said second selected regions.

It has been found that certain hardening techniques, which can render certain polymeric positive photoresists insoluble in the solvents in which they would otherwise be dissolved, are selectively operable on only the polymeric portions of an exposed but not yet developed layer, so that it is not necessary to develop the first layer to remove the exposed monomer from it before hardening, as was heretofore the practice. After the second photoresist layer is formed over the first and exposed to actinic depolymerizing radiation, normally defining an area somewhat larger than that of the first photoresist layer but coaxial therewith, both monomeric regions can be removed in a single development step. Such selective hardening techniques include properly controlled overall exposure to plasmas of certain gases or to positive ion bombardment, and are postulated to include ultraviolet irradiation over a range of wavelengths which crosslink but do not depolymerize.

The term "actinic" will be employed hereinafter exclusively to describe normal depolymerizing radiation, as distinguished from those wavelengths of ultraviolet which are postulated to selectively harden (crosslink) without causing substantial depolymerization.

In one embodiment, the selective hardening process allows fabrication with a second, effective pinhole covering type, layer without adversely affecting the good resolution provided by the thin first photoresist layer, while also reducing the number of handling steps to which the substrate must be subjected.

The above described feature of the invention, and another feature to be described, take advantage of the fact that the selectively hardened and crosslinked surface regions of the first photoresist layer were found to act as a screen during subsequent exposure of the second layer to actinic radiation, which radiation would otherwise depolymerize all underlying first layer polymer. In particular, the actinic radiation masking function of the hardened areas in the first photoresist layer prevents depolymerization of the first layer to the extent of the coarser pattern in the second photoresist layer.

Examples of commercially available photoresist materials exhibiting the aforementioned selective hardening features are type AZ4210 positive photoresist manufactured by American Hoerch Corporation and type HPR204 positive photoresist manufactured by Hunt Chemical Company.

An alternative approach is disclosed in U.S. Patent No. 4,352,820 issued to Howard et al., which discloses the use of a two layer resist composition wherein the upper thin layer of resist is used as a high resolution mask to control electron beam removal of the lower photoresist layer. Backscattered electrons provide a measure of undercut to control the resolution of the system. Because of the nature of the undercutting process, a basic restriction on unsupported spans between apertures is imposed (column 4, lines 60-63), a limitation not present in the process of the present invention.

One embodiments of the invention will now be described by way of example with reference to the accompanying drawings in which:

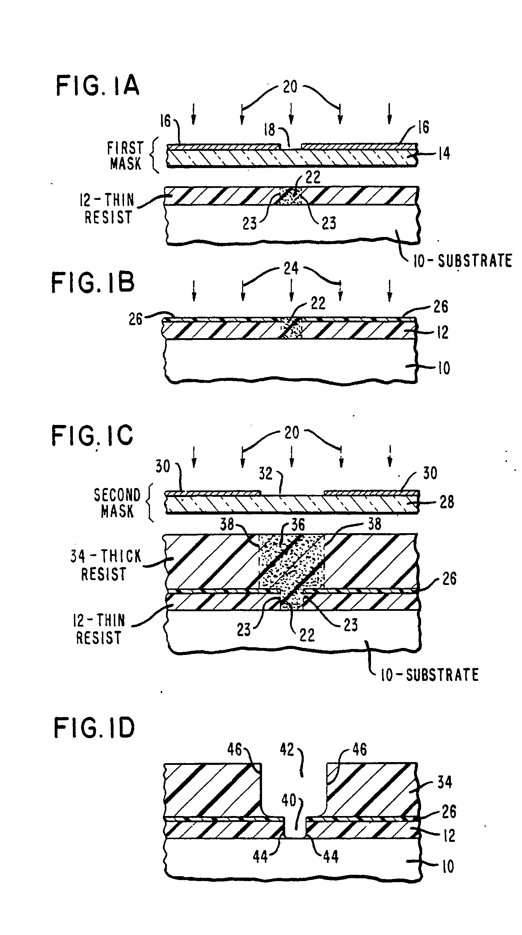

Figs. 1A-1D are cross-section views of a substrate subjected to a two layer photoresist process according to the present invention, showing pattern exposure depolymerizing a small circular central region of a photoresist film deposited on a substrate, the film and substrate after selective surface hardening of the upper surface of the photoresist layer, a subsequent exposure of a larger circular surrounding region in a second photoresist layer applied over the first layer, and the structure after a single final development respectively; and

Figs. 2A-2D are cross-section views of a substrate subjected to a two photoresist process representative of a contrasting process which is helpful in understanding the present invention.

The selective hardening feature of certain processes on certain positive photoresists, as mentioned hereinabove, permits substantial improvement in two areas of photolithographic (photoresist) technology, namely the fabrication of high resolution pinhole-free photoresist mask patterns and the fabrication of such patterns using thick "planarizing" photoresist layers. In more detail, it has been found that if a solid polymeric film of positive photoresist such as the type AZ4210 manufactured by American Hoerch Corporation or type HPR204 manufactured by Hunt Chemical Company is locally exposed by standard actinic radiation of wavelength about 400 nanometers, thereby converting the exposed areas from polymeric to monomeric form, and next generally exposed overall to a discharge plasma of a chosen gas or mixture of gases, two things occur: first, the surface of the polymeric regions is rendered substantially insoluble in the polymeric photoresist carrier solvent, while the monomeric regions remain soluble in the standard sodium hydroxide based developer used to selectively extract the monomer, i.e. to develop the pattern images; and second, the polymeric regions so treated or "selectively hardened" are substantially opaque to subsequent exposures of actinic radiation which would normally cause the depolymerization thereof.

Such selective hardening has been accomplished by using nitrogen, helium or argon plasmas, and by other forms of positive ion bombardment, e.g. sputtering bombardment and ion implant. Additionally, it can be reasonably postulated that since the monomeric form is the lowest energy state of the chemical system, i.e. the most stable state, requiring the most energy to crosslink (harden), and since it is known from the spectral selectivity of the above-mentioned resist material that long exposure is necessary to secure substantial crosslinking at shorter wavelengths, e.g. 280 nanometers, it can be expected that controlled exposure to such short wavelength radiation would also achieve the same selective hardening of the surface without inducing substantial depolymerization.

A specific application of both of the above-mentioned features of the selective hardening processes is illustrated in Figs. 1A through 1D, illustrating, for example, the formation of a small circular aperture protected by a second, thicker pinhole sealing layer having a somewhat larger communicating aperture or passage therein. As shown in Fig. 1A, a substrate 10 is coated with a high resolution first layer 12 of suitable photoresist polymer, the layer thickness being chosen to be nominally in the 500 nanometer range for optimum resolution. The polymer is preferably applied in lacquer form in a carrier solvent, after which the solvent is evaporated in a conventional way. To produce a given aperture in the first layer 12, a photoresist mask including transparent plate 14 having an opaque metallic patterned layer 16 thereon, with an aperture 18 therein, is placed in proximity to the upper surface of the first layer 12. By illuminating the upper surface of the mask with collimated actinic radiation, here shown schematically represented by parallel arrows 20-20, a local depolymerization of the first layer 12 polymer to a monomer is induced in the region generally indicated as 22 and having a boundary 23. At this point a latent image of aperture 18 exists within region 22 of the first layer 12.

The wafer in Fig. 1A is then subjected to selective surface hardening by exposure of the entire surface of the first layer to one of the hardening agents described above, as schematically indicated by the arrows 24-24 of Fig. 1B. This produces a crosslinked, very thin surface region 26 on the still polymerized portions of the first layer 12. Note, however, that monomer region 22 remains unaffected and lacking any surface region comparable to region 26.

As previously discussed, the hardening technique may involve ion bombardment using a gas plasma, direct ion bombardment from an ion source, or high energy irradiation using ultraviolet light having a wavelength which will crosslink the polymer without converting it to the monomeric form.

The preferred hardening process is the gas plasma process wherein the wafer 10 bearing the latent image 22 in the resist layer 12 is placed in a plasma chamber. A variety of systems are commercially available for plasma etching and photoresist removal, and may be adapted to produce selective hardening or crosslinking. One such unit, made by International Plasma Corporation of Hayward, California and designed for radio frequency excited plasma etching, can give reliable selective crosslinking when operated at a discharge excitation frequency of 13.5 MHz, a power of one-half kilowatt, and a gas pressure of 1 torr of nitrogen for twenty minutes. Selective crosslinking has also been secured by use of argon plasmas.

After such treatment the type AZ4210 photoresist previously mentioned will show selective crosslinking of the polymeric surface portion 26 in all regions except over the monomeric region 22. Such crosslinked layers are known to be insoluble in the normal sodium hydroxide based developer used with such resist.

Next, as shown in Fig. 1C, and prior to the use of any developer, a second layer 34 of preferably but not necessarily the same resist is applied over the first resist layer 12. The second layer 34 is thicker than the first layer 12, preferably at least twice as thick, a preferred thickness range being 2,000-3,000 nanometers. A second mask, with plate 28 having an aperture 32 in an opaque layer 30, allows incident collimated actinic radiation 20 to illuminate not only the original latent image region 22 of the first layer 12, but also a larger region 36 extending beyond the original latent image and having a boundary 38 associated therewith separating the central monomer region 36 produced by the second irradiation from the surrounding polymer portion. It will be noted that the latent image region 22 in the first layer 12 has been exposed twice at this point whereas the polymeric regions of first layer 12 falling beneath boundary 38 remain unexposed by virtue of opaque crosslinked surface region 26.

The wafer bearing the two photoresist layers 12 and 34 is then preferably developed in the conventional sodium hydroxide based developer appropriate for the resists. The finished photoresist mask pattern, depicted in Fig. 1D, shows a central aperture 40 having boundaries 44-44 communicating to a larger passage 42 in the upper resist layer 34.

The aperture profiles 44-44 and 46-46 as drawn in Fig. 1D are representative of the profiles produced in such double layer structures. This has been verified by electron microscopy. In particular, the inward encroachment of the walls 44-44 of the small aperture 40 and of the walls 46-46 of the large aperture as shown in Fig. 1D are of routinely encountered in developed photoresist patterns. It will be noted that such profiling tends to make the actual area of the substrate 10 which will be exposed to subsequent etching or other processing somewhat smaller than the mask aperture 18 shown in Fig. 1A. Such closing-down of apertures is a well-known aspect of photoresist technology, and is believed to have its origin in optical diffraction effects associated with the formation of small selectively illuminated areas in films of thickness of the order of a wavelength. As a result, the polymeric-monomeric transitions across such boundaries 38-38 and 23-23 are not abrupt, but tend to be gradual, and the boundary positions vary with depth as well, resulting in final boundaries as shown in Fig. 1D after development. For a given thickness of the first film 12, a minimum value is normally established for the aperture 18 of the first mask 14 (Fig. 1A), below which the lower boundary encroachment indicated by container 44-44 of Fig. 1D become too severe to tolerate. In extreme cases complete seal-off of the passage 40 occurs. It will therefore be appreciated that if a conventional two-layer photoresist process had been used wherein the pattern shown in Fig. 1A is first developed out and then crosslinked, followed by a second layer applied and exposed as shown in Fig. 1C, then a double exposure and development of the central aperture area would have been undertaken, possibly resulting in total blockage of the desired central aperture.

Figs. 2A through 2D illustrate a contrasting sequence wherein an initial pattern exposure is carried out (Fig. 2A), followed by developing and hardening to form a layer 26' (Fig. 2B), followed by a second application of photoresist wherein the polymer of the upper layer fills the lower aperture 40', followed by a second exposure (Fig. 2C), and a final development (Fig. 2D). As mentioned hereinabove, this contrasting sequence is helpful in comprehending the present invention, and is therefore described in detail.

It will be noted that after hardening (Fig. 2B), the small aperture wall boundaries 26" are effectively frozen, since the hardening of the walls 26" and surface 26' seals the underlying layer 12 against developer solvent action. On the other hand, no such wall barriers are present in the process shown in Figs. 1A-1D. In particular, it will be noted that further developable depolymerization of the wall boundary regions 23-23 (Fig. 1C) can be achieved during the second exposure. Thus, the final boundary profiles 44-44 (Fig. 1D) are well-resolved down to the substrate 10 after development. A smaller aperture 18 on the mask 14 may thus be used for initial exposure (Fig. 1A) without causing seal-off of the final aperture 40 of Fig. 1D.

The well defined wall profiles 44-44 of the small aperture 40 as shown in Fig. 1D are routinely observed, and would not in general be expected if the crosslinked surface portion 26 were transparent to the actinic radiation 20 during the step shown in Fig. 1C. If the crosslinked surface portion 26 were transparent, then a general conversion to monomer of the first layer 12 would occur at all points below the upper irradiated region defined by boundaries 38-38 thereof. If such were the case, then upon development it would be expected that the boundaries 44-44 of the central aperture of the pattern shown in Fig. 1D would be enlarged, having spread substantially under the crosslinked layer 26 as a result of the solvent action. That such is in fact not observed confirms that the crosslinked surface portion 26 is in fact opaque to the actinic radiation 20 used for depolymerization.

## Claims

1. A process for forming a layer of patterned photoresist on a substrate (10), including the steps of: forming on said substrate (10) a first layer of polymeric photoresist material (12); and converting first selected regions (22) of said first layer (12) to monomeric form by exposing said regions (22) to depolymerizing wavelength energy, characterized by the steps of: after said step of converting, conditioning said first layer (12), to form from a surface region of said polymeric photoresist material a surface layer (26) which is substantially opaque to depolymerizing wavelength energy without materially affecting said first selected regions (22); forming on said substrate (10) a second layer (34) of polymeric photoresist material having a thickness greater than the thickness of said first layer (12); converting to monomeric form second selected regions (36) of said second layer (34) overlying said selected regions (22) by exposing said second selected regions (36) to depolymerizing wavelength energy; and developing out the monomeric material from said first selected regions (22) and from said second selected regions (36).

2. A process according to claim 1, characterized in that the polymeric photoresist material in said first layer (12) is soluble in a carrier solvent of said second layer (34), and in that said surface layer (26) forms an insoluble barrier to said carrier solvent.

3. A process according to claim 1 or claim 2, characterized in that said second layer (34) is at least twice the thickness of said first layer (12).

## Revendications

1. Procédé pour former une couche de réserve photosensible configurée sur un substrat (10), comprenant les étapes qui consistent : à former sur ledit substrat (10) une première couche d'une matière polymérique de réserve photosensible (12) ; et à convertir des premières régions choisies (22) de ladite première couche (12) en une forme monomérique par exposition desdites régions (22) à une énergie ayant une longueur d'onde dépolymérisante, caractérisé par les étapes qui consistent : après ladite étape de conversion, à conditionner ladite première couche (12) pour former, à partir d'une région de la surface de ladite matière polymérique de réserve photosensible, une couche de surface (26) qui est sensiblement opaque à l'énergie à longueur d'onde dépolymérisante sans affecter matériellement lesdites premières régions choisies (22) ; à former sur ledit substrat (10) une seconde couche (34) de matière polymérique de réserve photosensible ayant une épaisseur supérieure à l'épaisseur de ladite première couche (12) ; à convertir en une forme monomérique des secondes régions choisies (36) de ladite seconde couche (34) s'étendant au-dessus desdites régions choisies (22) en exposant lesdites secondes régions choisies (36) à une énergie à longueur d'onde dépolymérisante ; et à développer la matière monomérique à partir desdites premières régions choisies (22) et desdites secondes régions choisies (36).

2. Procédé selon la revendication 1, caractérisé en ce que la matière polymérique de réserve photosensible dans ladite première couche (12) est soluble dans un solvant véhiculeur de ladite seconde couche (34), et en ce que ladite couche de surface (26) forme une barrière insoluble pour ledit solvant véhiculeur.

3. Procédé selon la revendication 1 ou la revendication 2, caractérisé en ce que ladite seconde couche (34) est au moins double de l'épaisseur de ladite première couche (12).

**Ansprüche**

1. Verfahren zum Bilden einer Schicht von Fotoresistmaterial in Musterform auf einem Substrat (10) mit den Schritten: Bilden einer ersten Schicht eines polymeren Fotoresistmaterials (12) auf dem Substrat (10); und Umwandeln erster ausgewählter Bereiche (22) der ersten Schicht (12) in eine monomere Form durch Aussetzen der Bereiche (22) einer depolymerisierenden Wellenlängenenergie; gekennzeichnet durch die Schritte: Konditionieren der ersten Schicht (12) nach dem Umwandlungsschritt, um aus einem Oberflächenbereich des polymeren Fotoresistmaterials eine Oberflächenschicht (26) zu bilden, die im wesentlichen undurchlässig für depolymerisierende Wellenlängenenergie ist, ohne die ersten ausgewählten Bereiche (22) wesentlich zu beeinflussen; Bilden einer zweiten Schicht (34) von polymerem Fotoresistmaterial auf dem Substrat (10) mit einer Dicke größer als die Dicke der ersten Schicht (12); Umwandeln zweiter ausgewählter Bereiche (36) der zweiten Schicht (34) über den ausgewählten Bereichen (22) durch Aussetzen der zweiten gewählten Bereiche (36) einer depolymerisierenden Wellenlängenenergie; und Herausentwickeln des monomeren Materials aus den ersten gewählten Bereichen (22) und aus den zweiten gewählten Bereichen (36).

2. Verfahren nach Anspruch 1, dadurch gekennzeichnet, daß das polymere Fotoresistmaterial in der ersten Schicht (12) in einem Trägerlösungsmittel der zweiten Schicht (34) lösbar ist und daß die Oberflächenschicht (26) eine unlösliche Barriere für das Trägerlösungsmittel bildet.

3. Verfahren nach Anspruch 1 oder 2, dadurch gekennzeichnet, daß die Dicke der zweiten Schicht (34) zumindest die doppelte Dicke der ersten Schicht (12) hat.

FIG. IA

FIG. IB

FIG. IC

FIG. ID

FIG.2A

FIG.2B

FIG.2C

FIG.2D